(19) Europäisches Patentamt

European Patent Office

Office européen des brevets

(11) EP 1 274 131 A1

(12) DEMANDE DE BREVET EUROPEEN

(43) Date de publication:
08.01.2003 Bulletin 2003/02

(51) Int Cl.⁷: H01L 27/02, H01L 21/8247

(21) Numéro de dépôt: 02012964.9

(22) Date de dépôt: 12.06.2002

(84) Etats contractants désignés:
AT BE CH CY DE DK ES FI FR GB GR IE IT LI LU
MC NL PT SE TR
Etats d'extension désignés:
AL LT LV MK RO SI

(30) Priorité: 02.07.2001 FR 0108776

(71) Demandeur: STMicroelectronics
92120 Montrouge (FR)

(72) Inventeurs:
• Boivin, Philippe
13770 Venelles (FR)
• La Rosa, Francesco
Quartier Tartanne, 13790 Rousset (FR)

(74) Mandataire: Marchand, André
OMNIPAT,
24 Place des Martyrs de la Résistance
13100 Aix-en-Provence (FR)

(54) **Contact antistatique pour ligne en silicum polycristallin**

(57) La présente invention concerne un circuit intégré (20) sur substrat de silicium (1) comprenant au
moins une ligne de polysilicium (4) et au moins un contact antistatique reliant la ligne de polysilicium au substrat de silicium. Selon l'invention, le contact antistatique
(21) comprend une couche d'oxyde fin (22) entre la ligne
de polysilicium et le substrat de silicium. La couche
d'oxyde fin est d'une épaisseur suffisamment faible pour
qu'un courant la traverse par effet tunnel lorsque la ligne
de polysilicium est portée relativement au substrat à une
tension (V1) supérieure ou inférieure à un seuil déterminé (Vc1, Vc2).

Fig. 2

EP 1 274 131 A1

**Description**

La présente invention concerne les circuits intégrés et plus particulièrement les circuits intégrés comprenant des lignes conductrices en polysilicium (silicium polycristallin).

Dans les circuits intégrés CMOS, le polysilicium est utilisé aussi bien pour réaliser des grilles de transistors MOS que pour créer des lignes d'interconnexion de transistors MOS. Ainsi, par exemple, les diverses lignes conductrices reliant les transistors à grille flottante d'une mémoire effaçable et programmable électriquement, notamment les lignes de mots et les lignes de contrôle de grille (mémoires EEPROM), sont généralement en polysilicium.

Pour réaliser de telles lignes de polysilicium, une couche de polysilicium est déposée à la surface d'une plaquette de silicium avec interposition d'une couche d'oxyde, et est ensuite gravée selon la topographie souhaitée ("layout"). Les lignes de polysilicium étant isolées électriquement du substrat de silicium par la couche d'oxyde, elles forment chacune l'équivalent d'une armature de condensateur dont l'autre armature est formée par le substrat.

Or, les procédés de fabrication de circuits intégrés comprennent des étapes qui induisent des charges électrostatiques dans les lignes de polysilicium, notamment des étapes nécessitant l'utilisation de plasma comme des étapes de gravure au plasma et des étapes d'implantation de dopants. Ainsi, les lignes de polysilicium se retrouvent souvent portées à un potentiel électrique élevé dû à une accumulation de charges électrostatiques, pouvant atteindre plusieurs dizaines de Volt. Un tel potentiel électrique induit un fort champ électrique dans les régions où la couche d'oxyde est la plus fine, notamment des régions d'oxyde de grille des transistors MOS. Ce phénomène peut conduire à une dégradation des performances des transistors MOS voire au claquage de l'oxyde de grille.

Pour résoudre ce problème, il est connu de protéger les lignes de polysilicium contre l'accumulation de charges électrostatiques par la prévision de contacts antistatiques. On désigne par "contact antistatique" tout moyen offrant un chemin de conduction privilégié pour l'évacuation de ces charges, sous la forme d'un faible courant pouvant s'écouler dans le sens polysilicium vers substrat ou inversement sans affecter le fonctionnement d'un circuit intégré.

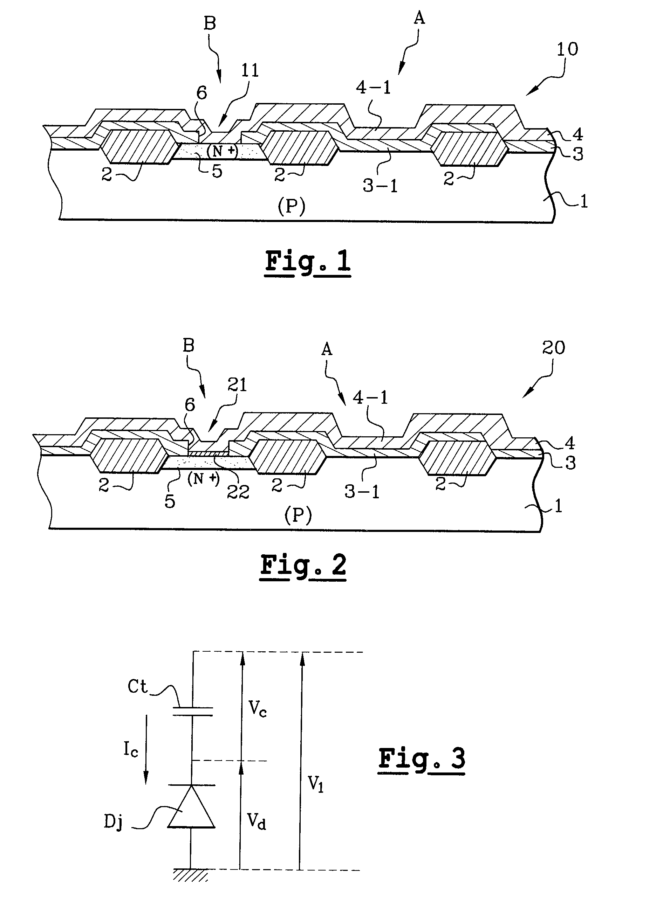

La figure 1 est une vue partielle en coupe d'un circuit intégré 10 en cours de fabrication, et représente une structure classique de contact antistatique 11, appelé également contact enterré. On distingue un substrat de silicium 1, ici de type P, sur lequel ont été formées des régions d'oxyde de champ 2 qui délimitent respectivement une région active A, destinée à recevoir des grilles de transistor MOS, et une région non active B. L'ensemble est recouvert par une couche d'oxyde 3 formant dans la région active un oxyde de grille 3-1, et par une couche de polysilicium 4 formant dans la région active un matériau de grille 4-1. Avant le dépôt de la couche d'oxyde 3, une région 5 dopée N+ a été implantée dans le substrat au niveau de la zone B. Avant le dépôt de la couche de polysilicium 4, une ouverture 6 a été pratiquée dans la couche d'oxyde 3, au-dessus de la région dopée 5. Ainsi, lorsque la couche de polysilicium 4 est déposée, celle-ci se trouve au contact de la région 5 par l'intermédiaire de l'ouverture 6, ce qui forme un contact antistatique 11. La région 5 étant dopée N+, la couche de polysilicium 4 est reliée électriquement au potentiel du substrat 1 par l'intermédiaire d'une jonction NP formant diode. Cette jonction NP empêche le polysilicium de se charger négativement relativement au substrat et, en cas de charge positive, laisse passer un courant de fuite qui est suffisant pour éviter un claquage de la couche d'oxyde dans la région active. Lorsque le circuit intégré 10 est terminé et est opérationnel, la couche de polysilicium 4 reçoit une tension positive, le substrat étant porté à la masse, la jonction NP est polarisée en inverse et sa présence ne nuit pas au fonctionnement du circuit intégré. Bien entendu, une jonction PN peut être prévue à la place de la jonction NP si la couche de polysilicium est destinée à recevoir une tension négative relativement au substrat lorsque le circuit intégré est opérationnel.

Bien que la combinaison d'un tel contact antistatique 11 et d'une jonction NP ou PN offre entière satisfaction en ce qui concerne l'évacuation des charges électrostatiques, la prévision d'un tel contact antistatique dans un circuit intégré entraîne diverses contraintes ou inconvénients au plan technologique.

Un premier inconvénient est que la couche de polysilicium 4 doit présenter un dopage de même type que la région 5, pour ne pas former avec la région 5 une jonction PN parasite. Il n'est donc pas possible de prévoir un dopage d'un autre type, même quand un tel dopage est souhaité.

Un autre inconvénient est que les dopants présents dans la couche de polysilicium 4 diffusent dans le substrat pendant des phases de recuit, et s'additionnent aux dopants présents dans la région 5. Il se produit ainsi une sorte de "pollution" du substrat par diffusion de dopants au voisinage du contact antistatique 11. En pratique, cela signifie que l'emplacement à réserver à un contact antistatique doit tenir compte de la diffusion de dopants au voisinage du contact antistatique, et que l'encombrement effectif du contact antistatique en termes de surface de silicium réservée n'est pas négligeable.

Enfin, dans le cadre de la réalisation d'un circuit intégré comprenant des transistors à grille flottante, l'obtention d'un contact direct entre le polysilicium et le substrat (au niveau de la région dopée 5) nécessite diverses étapes de traitement qui s'ajoutent à celles des procédés de fabrication standards. Ces étapes de traitement ont pour but de retirer, au fond de l'ouverture 6, une couche d'oxyde tunnel formée sur le circuit intégré avant la réalisation des transistors à grille flottante. La couche d'oxyde tunnel étant formée par croissance d'oxyde, elle se retrouve inévitablement au fond de l'ouverture. 6 car le processus de croissance n'est pas sélectif, et doit donc être ensuite retirée. Cette étape de retrait est complexe car un masque de résine ne peut être déposé directement sur la couche d'oxyde tunnel. On doit tout d'abord déposer une couche de polysilicium, graver la couche de polysilicium puis utiliser la couche de polysilicium gravée comme masque de gravure de l'oxyde tunnel présent au fond de l'ouverture 6.

Ainsi, un objectif de la présente invention est de prévoir une structure de contact antistatique qui ne présente pas les inconvénients mentionnés ci-dessus.

Plus particulièrement, la présente invention vise un contact antistatique dont l'obtention nécessite moins d'étapes de traitement que celle d'un contact antistatique classique, notamment dans le cadre de la réalisation d'un circuit intégré comprenant des transistors à grille flottante.

Cet objectif est atteint par la prévision d'un circuit intégré sur substrat de silicium comprenant au moins une ligne de polysilicium reliant une pluralité de composants électroniques tels que des transistors MOS, et au moins un contact antistatique reliant la ligne de polysilicium au substrat de silicium, dans lequel le contact antistatique comprend une couche d'oxyde fin agencée entre la ligne de polysilicium et le substrat de silicium, la couche d'oxyde fin étant d'une épaisseur suffisamment faible pour qu'un courant la traverse par effet tunnel lorsque la ligne de polysilicium est portée relativement au substrat à une tension supérieure ou inférieure à un seuil déterminé.

Selon un mode de réalisation, le contact antistatique est agencé au-dessus d'une région dopée formant avec le substrat une jonction NP ou PN.

Selon un mode de réalisation, la couche d'oxyde fin présente une épaisseur comprise entre 0,002 et 0,015 micromètre.

Selon un mode de réalisation, le circuit intégré comprend au moins un transistor à grille flottante présentant une grille flottante qui est isolée du substrat par une couche d'oxyde tunnel formant également la couche d'oxyde fin du contact antistatique.

Selon un mode de réalisation, le circuit intégré forme une mémoire effaçable et programmable électriquement.

La présente invention concerne également un procédé de fabrication d'un circuit intégré, comprenant la fabrication d'une ligne de polysilicium reliant une pluralité de composants électroniques tels que des transistors MOS, et d'au moins un contact antistatique entre une ligne de polysilicium et un substrat de silicium, comprenant les étapes consistant à : faire croître une première couche d'oxyde sur le substrat de silicium, pratiquer au moins une ouverture dans la première couche d'oxyde, faire croître une deuxième couche d'oxyde au fond de l'ouverture, déposer une couche de polysilicium qui pénètre dans l'ouverture, et graver la couche de polysilicium de manière à obtenir la ligne de polysilicium et de manière que celle-ci s'étende au-dessus de l'ouverture, procédé dans lequel la couche de polysilicium est déposée sans retrait préalable de la deuxième couche d'oxyde présente au fond de l'ouverture, la deuxième couche d'oxyde étant d'une épaisseur suffisamment faible pour qu'un courant la traverse par effet tunnel lorsque la ligne de polysilicium est portée relativement au substrat à une tension supérieure ou inférieure à un seuil déterminé.

Selon un mode de réalisation, le procédé comprend une étape de gravure de la couche de polysilicium de manière à obtenir simultanément la ligne de polysilicium s'étendant au-dessus de l'ouverture et au moins une grille flottante d'un transistor à grille flottante, la grille flottante ne présentant pas de continuité électrique avec la ligne de polysilicium.

Selon un mode de réalisation, le procédé comprend une étape d'implantation de dopants dans le substrat, dans une région se trouvant en regard de l'ouverture pratiquée dans la première couche d'oxyde, pour former une jonction NP ou PN relativement au substrat.

Selon un mode de réalisation, le circuit intégré est une mémoire effaçable et programmable électriquement.

Ces objets, caractéristiques et avantages de la présente invention seront exposés plus en détail dans la description suivante d'un exemple de réalisation d'un contact antistatique selon l'invention et d'un procédé de fabrication d'un tel contact antistatique, faite en relation avec les figures jointes parmi lesquelles :

- la figure 1 précédemment décrite est une vue en coupe partielle d'un circuit intégré comprenant un contact antistatique classique,
- la figure 2 est une vue en coupe partielle d'un circuit intégré comprenant un contact antistatique selon l'invention,
- la figure 3 est le schéma électrique de la combinaison d'un contact antistatique selon l'invention et d'une jonction NP,
- les figures 4, 5 et 6 représentent des courbes courant-tension qui illustrent les propriétés électriques d'un contact antistatique selon l'invention, et
- la figure 7 est une vue de dessus d'un circuit intégré comprenant un contact antistatique selon l'invention,
- les figures 8A à 8E illustrent des étapes d'un procédé de fabrication d'un circuit intégré selon l'invention.

La figure 2 est une vue partielle en coupe d'un circuit intégré 20 comprenant un contact antistatique 21 selon l'invention. La partie de circuit intégré représentée ici est identique à celle de la figure 1, les mêmes éléments étant désignés par les mêmes références. On y retrouve un substrat 1 de type P, des zones d'oxyde de champ 2 séparant une région active A et une région non active B, une couche d'oxyde 3 déposée sur le substrat 1, une couche de polysilicium 4 déposée sur la couche d'oxyde 3, la couche d'oxyde 3 formant oxyde de grille 3-1 et la couche de polysilicium formant matériau de grille 4-1 dans la zone active A.

Le contact antistatique 21 selon l'invention, réalisé dans la zone B, comprend classiquement une ouverture 6 pratiquée dans la couche d'oxyde 3, dans laquelle pénètre le polysilicium 4. Selon l'invention, le polysilicium 4 n'est pas au contact du substrat 1 car le contact antistatique 22 comprend une couche d'oxyde fin 22 agencée au fond de l'ouverture 6, qui sépare le polysilicium 4 du substrat 1. En dessous de la couche d'oxyde 22 se trouve classiquement une région 5 dopée N+ formant une jonction NP avec le reste du substrat.

Selon l'invention, la couche d'oxyde fin 22 offre une bonne isolation électrique de la couche de polysilicium 4 relativement au substrat 1 lorsque la couche de polysilicium 4 reçoit une tension électrique de quelques Volt. Toutefois, lorsque la tension augmente suite à l'accumulation de charges électrostatiques dans la couche de polysilicium 4, la couche d'oxyde fin 22 laisse passer un courant de décharge Ic. Un tel courant Ic apparaît par effet tunnel (effet Fowler-Nordheim) et répond à la relation suivante :

$$(1)\ Ic = A\ Eox^2\ e^{(-B/E_{ox})}$$

dans laquelle A et B sont des constantes et Eox le champ électrique dans l'oxyde fin 22.

La prévision d'une jonction NP ou PN classique sous le contact antistatique 21 selon l'invention apparaît comme une protection indispensable en cas de claquage de la couche d'oxyde fin 22. Si un tel claquage se produit, un contact ohmique apparaît entre la ligne de polysilicium 4 et la région 5 dopée N+ du substrat 1. La jonction NP ou PN se trouve polarisée en inverse quand le circuit intégré est opérationnel et empêche l'apparition d'un court-circuit entre la ligne de polysilicium 4 et le potentiel du substrat 1. En définitive, un contact antistatique selon l'invention dont l'oxyde fin 22 a claqué présente sensiblement les mêmes propriétés électriques qu'un contact antistatique classique.

Un tel contact antistatique 21 présente divers avantages. D'une part, il n'est pas nécessaire que la couche de polysilicium 4 présente le même dopage que la région 5 car elle est isolée de celle-ci par la couche d'oxyde fin 22. D'autre part, toujours grâce à la couche d'oxyde fin 22, les dopants présents dans la couche de polysilicium 4 ne diffusent pas dans le substrat pendant des phases de recuit, et ne s'additionnent pas aux dopants présents dans la région 5. En d'autres termes, la "pollution" localisée du substrat par diffusion de dopants au voisinage du contact antistatique 21 est plus faible que dans l'art antérieur. L'emplacement à réserver au contact antistatique 21 est donc plus faible que dans l'art antérieur.

Enfin, comme cela sera vu plus loin au moyen d'un exemple, un autre avantage d'un tel contact antistatique est d'être simple à obtenir dans le cadre de la fabrication d'un circuit intégré comprenant des transistors à grille flottante, la couche d'oxyde tunnel des grilles flottantes pouvant être utilisée comme couche d'oxyde fin 22.

Avant de décrire cet avantage technologique, on va tout d'abord démontrer que la combinaison du contact antistatique 21 selon l'invention et de la jonction NP (ou PN) formée entre la région 5 et le substrat permet l'écoulement d'un courant Ic lorsque la ligne de polysilicium 4 est soumise à une tension électrostatique élevée.

La figure 3 est le schéma électrique de la combinaison d'un contact antistatique selon l'invention et d'une jonction NP. Le contact antistatique est schématisé par une capacité tunnel Ct en série avec une diode Dj représentant la jonction NP. La capacité Ct reçoit sur son anode une tension V1, qui est considérée ici comme une tension électrostatique pouvant apparaître sur une ligne de polysilicium pendant la fabrication d'un circuit intégré. La diode Dj est polarisée en inverse, la cathode de la diode étant reliée à la cathode de la capacité Ct, son anode étant à la masse (potentiel du substrat). La tension aux bornes de la capacité Ct est désignée Vc et la tension aux bornes de la diode Dj est désignée Vd. La somme des tensions Vc et Vd étant égale à la tension V1 puisque les deux éléments en série forment un pont diviseur de tension.

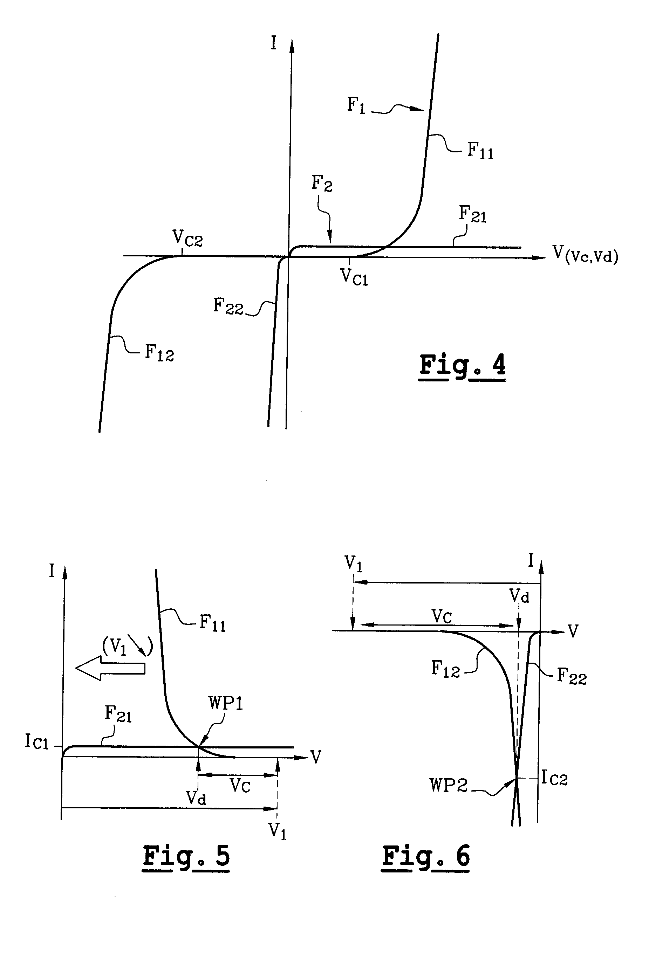

La figure 4 représente la courbe courant/tension F1 de la capacité tunnel Ct, laquelle correspond à la relation (1) mentionnée ci-dessus, et représente également la courbe courant/tension F2 de la diode Dj. La courbe F1 comprend une demi-courbe F11 pour les tensions positives et une demi-courbe F12 pour les tensions négatives. On voit qu'un courant commence à traverser la capacité tunnel Ct lorsque la tension Vc à ses bornes est supérieure à une tension de seuil positive Vc1 ou est inférieure à une tension de seuil négative Vc2. Par ailleurs, la courbe F2 de la diode Dj comprend une demi-courbe F21 pour les tensions positives (courbe courant/tension classique d'une diode polarisée en inverse) et une demi-courbe F22 pour les tensions négatives (courbe courant/tension classique d'une diode polarisée dans le sens passant).

Pour vérifier qu'un courant de décharge électrostatique va circuler dans l'ensemble formé par la capacité tunnel Ct et la diode Dj, considérons tout d'abord qu'une tension V1 positive supérieure à Vc1 apparaît dans la ligne en polysilicium. Pour qu'un courant circule, il doit exister un point de fonctionnement commun entre la capacité tunnel Ct et la diode Dj. Pour vérifier l'existence d'un tel point de fonctionnement, les deux demi-courbes F11 et F21 sont reportées sur un même graphique, illustré en figure 5, correspondant au cadran des tensions et des courants positifs de la figure 4. Conformément aux règles de l'art, la demi-courbe F11 est reportée dans ce cadran en la faisant pivoter de 180° autour de l'axe des courant I (V=0) puis en la décalant sur l'axe des tensions d'une valeur égale à V1. Il apparaît que les demi-courbes F11 et F21 se croisent en un point de fonctionnement WP1 correspondant à un courant Ic1. L'existence d'un tel point de fonctionnement garantit l'écoulement des charges électrostatiques. Si la tension V1 diminue (par exemple en raison de l'évacuation des charges électrostatiques) la courbe F11 se déplace vers la gauche du schéma comme représenté par une flèche et le courant Ic1 reste constant en raison de la forme plate de la courbe F21 (courant de fuite dans une diode polarisée en inverse). Si la tension V1 continue à diminuer, la courbe F11 se trouve en dehors du cadran et ne croise plus la courbe F21, de sorte que le courant de décharge Ic n'existe plus.

Une vérification similaire peut être faite en considérant qu'une tension V1 négative inférieure à Vc2 apparaît dans la ligne en polysilicium. Pour s'assurer qu'il existe un point de fonctionnement commun, les deux demi-courbes F12 et F22 sont reportées sur un même graphique, représenté en figure 6, correspondant au cadran des tensions et des courants négatifs de la figure 4. La demi-courbe F12 est reportée en la faisant pivoter de 180° autour de l'axe des courants I (V=0) puis en la décalant sur l'axe des tensions d'une valeur égale à -V1. Ici également, il apparaît que les demi-courbes F11 et F21 présentent un point de fonctionnement commun WP2 où elles se croisent, correspondant à un courant négatif Ic2, ce qui garantit l'écoulement des charges électrostatiques. Au fur et à mesure que la tension V1 augmente et se rapproche de zéro (par exemple en raison de l'évacuation des charges électrostatiques), la demi-courbe F12 se délace vers la droite du cadran et le courant Ic2 diminue jusqu'à devenir nul.

En définitive, la combinaison d'un contact antistatique selon l'invention et d'une jonction NP ou PN assure un écoulement suffisant des charges électrostatiques lorsque la tension V1 apparaissant dans la ligne de polysilicium dépasse un certain seuil Vc1, Vc2.

Par ailleurs, comme on l'a indiqué plus haut, l'hypothèse d'un claquage éventuel de l'oxyde fin du contact antistatique ne constitue pas un inconvénient puisque le contact antistatique selon l'invention devient alors l'équivalent d'un contact antistatique classique.

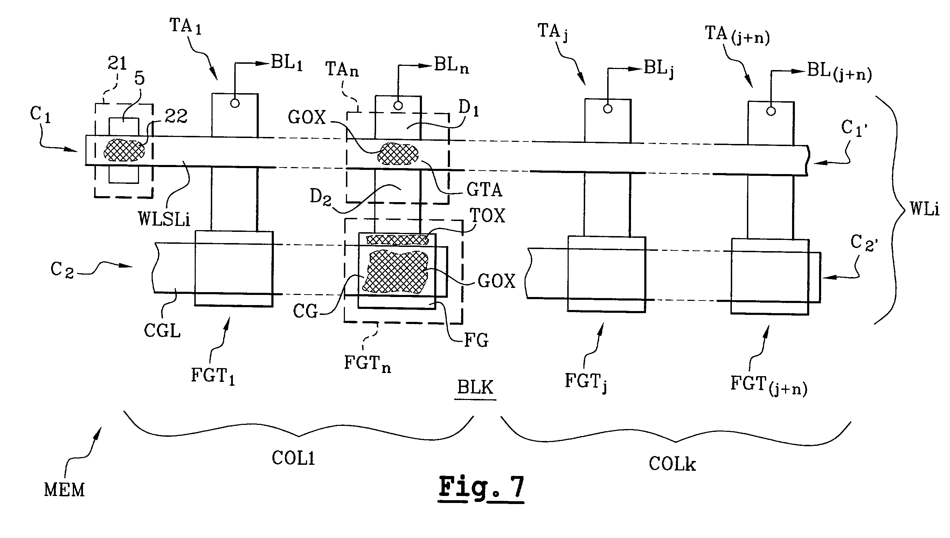

La figure 7 illustre une application de la présente invention à la protection de lignes de polysilicium présentes dans les mémoires effaçables et programmables électriquement. La figure 7 représente très schématiquement, par une vue de dessus, la topographie d'une ligne de mot WLi de rang i d'une mémoire MEM effaçable et programmable électriquement. La ligne de mot WLi comprend une pluralité de transistors à grille flottante FGT1-FGTn,... FGTj-FGT(j+n),... agencés en colonnes COL1,... COLk,... Chaque colonne comprend n transistors FGT et chaque transistor FGT comprend une grille flottante FG en polysilicium et une grille de contrôle CG. La grille de contrôle CG s'étend au-dessus de la grille flottante FG et est séparée de celle-ci par une couche d'oxyde de grille GOX. La grille flottante FG s'étend au-dessus d'un substrat de silicium BLK et est séparée de celui-ci par une couche d'oxyde tunnel TOX. Les oxydes GOX et TOX sont repérés par des traits hachurés sur la figure mais se trouvent en réalité sous la grille de contrôle CG et sous la grille flottante FG. La grille de contrôle CG est un tronçon d'une ligne de contrôle de grille CGL qui passe au-dessus des grilles flottantes de tous les transistors FGT d'une même colonne.

Chaque transistor FGT est connecté à une ligne de bit BL de rang correspondant (BL1-BLn...BLj-BL (j+n)...) par l'intermédiaire d'un transistor d'accès TA (TA1-TAn...TAj-TA(j+n)). Le transistor d'accès TA comprend deux régions dopées D1, D2 formant régions de drain et de source, s'étendant de part et d'autre d'une grille GTA en polysilicium. Entre la grille GTA et le substrat BLK se trouve un oxyde de grille GOX.

Dans une telle mémoire, les grilles GTA des transistors d'accès TA appartenant à la même ligne de mot WLi sont reliées à une ligne commune WLSLi (ligne de sélection de ligne de mot). La ligne WLSLi est en polysilicium et passe entre les régions D1 et D2, où elle forme les grilles GTA des transistors d'accès TA. Une telle ligne WLSLi est d'une grande longueur relativement aux autres lignes de polysilicium car elle traverse tout le plan mémoire horizontalement pour interconnecter les grilles GTA des transistors d'accès. Elle se comporte comme une "antenne" en présence de charges électriques et doit être protégée contre l'accumulation de charges pouvant endommager les oxydes de grille GOX des transistors d'accès TA.

On prévoit ainsi, à une extrémité de la ligne WLSLi, un contact antistatique 21 selon l'invention. Celui-ci comprend la région dopée 5 décrite plus haut, implantée dans le substrat BLK, et la couche d'oxyde fin 22 s'étendant sous la ligne WLSLi.

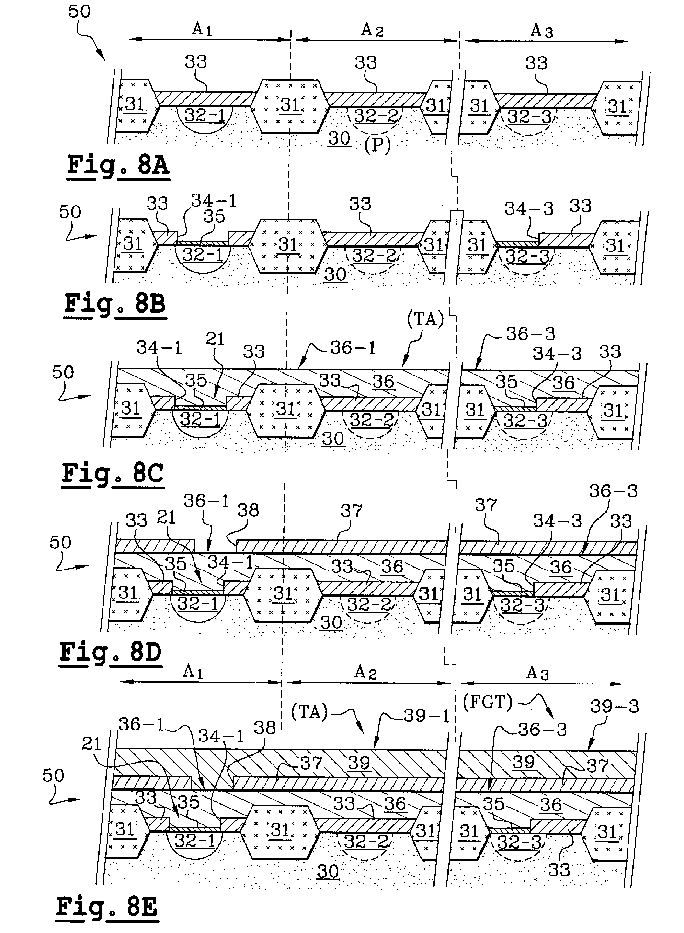

Les figures 8A à 8E sont des vues en coupe illustrant des étapes d'un procédé de fabrication d'un circuit intégré 50 comprenant la fabrication conjointe d'un contact antistatique selon l'invention et d'une grille de transistor à grille flottante. Chaque figure présente une partie gauche et une partie droite correspondant à des axes de coupe différents, par exemple un axe C1-C1' représenté en figure 7 pour la partie gauche de chaque figure et un axe de coupe C2-C2' pour la partie droite de chaque figure. Les épaisseurs des diverses couches de matériaux ne sont pas représentées à l'échelle dans un souci de lisibilité de ces figures.

Comme illustré en figure 8A, des régions A1, A2, A3 sont tout d'abord délimitées à la surface d'un substrat de silicium 30, ici de type P, grâce à des barrières d'isolement 31 réalisées au moyen d'un procédé standard d'isolement (oxyde épais, LOCOS, STI...). Des régions 32-1, 32-2, 32-3 dopées N+ sont ensuite implantées dans le substrat, respectivement dans chacune des régions A1, A2, A3. Les régions 32-2 et 32-3 sont représentées en traits pointillés car elles ne se trouvent pas dans le plan de coupe (comme par exemple la région D1 ou D2 en figure 7). Une couche d'oxyde de grille 33 est ensuite formée sur l'ensemble du substrat par croissance d'oxyde. Dans un souci de clarté de la figure, l'oxyde 33 se trouvant sur les barrières d'isolement 31 n'est pas représenté.

A l'étape illustrée en figure 8B, des ouvertures 34-1 et 34-3 sont pratiquées dans la couche d'oxyde 33, dans les régions A1 et A3, par gravure de la couche d'oxyde. Une couche d'oxyde tunnel 35 est ensuite formée sur l'ensemble du substrat, par croissance d'oxyde. La couche d'oxyde tunnel 35 est typiquement d'une épaisseur de l'ordre de 0,002 à 0,015 micromètre selon la technologie de fabrication utilisée et la tension d'alimentation que le circuit intégré est destiné à recevoir. La couche d'oxyde de grille 33 est d'une épaisseur nettement supérieure, généralement de l'ordre de quelques centièmes de micromètres.

Dans un souci de clarté de la figure, l'oxyde tunnel 35 formé sur les barrières d'isolement 31 et sur la couche d'oxyde de grille 33 n'est pas représenté, son épaisseur étant négligeable, seul l'oxyde tunnel 35 formé au fond des ouvertures 34-1 et 34-3 étant représenté.

A l'étape illustrée en figure 8C, une couche de polysilicium 36 est déposée sur l'ensemble du substrat, puis est gravée pour faire apparaître des lignes d'interconnexion, des grilles de transistors MOS et des grilles flottantes de transistors FGT. En particulier, une ligne de polysilicium 36-1 est formée dans les régions A1 et A2 et une grille flottante 36-3 est formée dans la région A3. La ligne de polysilicium 36-1 s'étend dans l'ouverture 34-1 où elle vient au contact de l'oxyde tunnel 35 s'étendant au-dessus du substrat (région dopée 32-1), l'ensemble formant ainsi un contact antistatique 21 selon l'invention. Ainsi, pendant la gravure de la ligne de polysilicium 36-1 et les étapes ultérieures du procédé de fabrication, la ligne de polysilicium 36-1 est protégée contre l'accumulation de charges électrostatiques.

A l'étape illustrée en figure 8D, une couche isolante 37 est formée sur l'ensemble du substrat, par croissance ou dépôt d'oxyde ou d'un isolant de type ONO (Oxyde-Nitrure-Oxyde). Une ouverture 38 est ensuite pratiquée dans la couche isolante 37, au-dessus de la ligne de polysilicium 36-1, par gravure de la couche 37.

A l'étape illustrée en figure 8E, une couche de polysilicium 39 est déposée sur la couche isolante 37, puis est gravée pour faire apparaître des lignes d'interconnexion et des grilles de contrôle de transistors à grille flottante FGT. En particulier, une grille de contrôle 39-3 est réalisée au-dessus de la grille flottante 36-3 et une ligne 39-1 est réalisée au-dessus de la ligne 36-1. La ligne 39-1 est en contact avec la ligne 36-1 grâce à l'ouverture 38 pratiquée dans la couche isolante 37, et se trouve ainsi reliée au substrat par l'intermédiaire du contact antistatique 21, qui la protège également contre l'accumulation de charges électrostatiques. Les lignes 36-1 et 39-1 forment par exemple une ligne de sélection de ligne de mot WLSLi du type décrit plus haut (fig. 7). La ligne 36-1 forme également, dans la région A2 et en regard de la région dopée 32-2, une grille de transistor d'accès TA.

En définitive, la fabrication d'un contact antistatique selon l'invention ne comprend aucune étape de retrait de l'oxyde tunnel et s'intègre parfaitement dans le processus de fabrication d'un circuit intégré, sans nécessiter d'étape de traitement supplémentaire, étant noté que l'ouverture 34-1 dans la couche d'oxyde 33 est réalisée en même temps que l'ouverture 34-3 et autres ouvertures du même type destinées à recevoir les grilles flottantes des transistors FGT. Par contre, la réalisation d'un contact antistatique classique nécessiterait le retrait de l'oxyde tunnel 35 se trouvant au fond de l'ouverture 34-1. A cet effet, étant donné qu'un masque de gravure ne peut être déposé directement sur de l'oxyde tunnel, une couche de polysilicium devrait tout d'abord être déposée sur l'oxyde tunnel. La couche de polysilicium devrait ensuite être gravée de manière à obtenir en regard de l'ouverture 34-1 une autre ouverture formant masque de gravure de l'oxyde tunnel.

## Revendications

1. Circuit intégré (20, 50) sur substrat de silicium (1, 30) comprenant au moins une ligne de polysilicium (4, 36-1, 39-1) reliant une pluralité de composants électroniques tels que des transistors MOS, et au moins un contact antistatique reliant la ligne de polysilicium au substrat de silicium, **caractérisé en ce que** le contact antistatique (21) comprend une couche d'oxyde fin (22, 35) agencée entre la ligne de polysilicium et le substrat de silicium, la couche d'oxyde fin étant d'une épaisseur suffisamment faible pour qu'un courant (Ic, Ic1, Ic2) la traverse par effet tunnel lorsque la ligne de polysilicium (4, 36-1, 39-1) est portée relativement au substrat à une tension (V1) supérieure ou inférieure à un seuil déterminé (Vc1, Vc2).

2. Circuit intégré selon la revendication 1, dans lequel le contact antistatique est agencé au-dessus d'une région dopée (5, 32-1) formant avec le substrat une jonction NP ou PN.

3. Circuit intégré selon l'une des revendications 1 et 2, dans laquelle la couche d'oxyde fin présente une épaisseur comprise entre 0,002 et 0,015 micromètre.

4. Circuit intégré selon la revendication 3, comprenant au moins un transistor (FGT) à grille flottante (36-3) présentant une grille flottante (36-3) qui est isolée du substrat (30) par une couche d'oxyde tunnel (35) formant également la couche d'oxyde fin du contact antistatique.

5. Circuit intégré selon l'une des revendications 1 à 4, formant une mémoire effaçable et programmable électriquement (MEM).

6. Procédé de fabrication d'un circuit intégré (50) comprenant la fabrication d'une ligne de polysilicium reliant une pluralité de composants électroniques tels que des transistors MOS, et d'au moins un contact antistatique entre la ligne de polysilicium (36-1) et un substrat de silicium (30), comprenant les étapes consistant à :

   - faire croître une première couche d'oxyde (33) sur le substrat de silicium (30),
   - pratiquer au moins une ouverture (34-1) dans la première couche d'oxyde (33),
   - faire croître une deuxième couche d'oxyde (35) au fond de l'ouverture (34-1),
   - déposer une couche de polysilicium (36) qui pénètre dans l'ouverture (34-1), et
   - graver la couche de polysilicium de manière à obtenir la ligne de polysilicium (36-1) et de manière que celle-ci s'étende au-dessus de l'ouverture (34-1),

   **caractérisé en ce que** la couche de polysilicium (36) est déposée sans retrait préalable de la deuxième couche d'oxyde (35) présente au fond de l'ouverture (34-1), et **en ce que** la deuxième couche d'oxyde (35) est d'une épaisseur suffisamment faible pour qu'un courant (Ic, Ic1, Ic2) la traverse par effet tunnel lorsque la ligne de polysilicium (36-1) est portée relativement au substrat à une tension (V1) supérieure ou inférieure à un seuil déterminé (Vc1, Vc2).

7. Procédé selon la revendication 6, comprenant une étape de gravure de la couche de polysilicium de manière à obtenir simultanément au moins la ligne de polysilicium (36-1) s'étendant au-dessus de l'ouverture (34-1) et au moins une grille flottante (36-3) d'un transistor à grille flottante, la grille flottante ne présentant pas de continuité électrique avec la ligne de polysilicium.

8. Procédé selon l'une des revendications 6 et 7, comprenant une étape d'implantation de dopants dans le substrat, dans une région (32-1) se trouvant en regard de l'ouverture (34-1) pratiquée dans la première couche d'oxyde (33), pour former une jonction NP ou PN relativement au substrat.

9. Procédé selon l'une des revendications 6 à 8, dans lequel le circuit intégré (50) est une mémoire effaçable et programmable électriquement (MEM).

**Fig. 1**

**Fig. 2**

**Fig. 3**

_Fig. 4_

_Fig. 5_

_Fig. 6_

**Fig. 7**

50

A₁          A₂          A₃

33          33          33

31  32-1  31  32-2  31  31  32-3  31

30  (P)

**Fig. 8A**

50

33  34-1  33  34-3  33
35

31  32-1  31  32-2  31  31  32-3  31

30

**Fig. 8B**

(TA)

34-1  21  33  36-1  36-3  34-3  33
35  33  36  35  36

31  32-1  31  32-2  31  31  32-3  31

30

**Fig. 8C**

33  21  36-1  38  37  37  36-3
35  34-1  33  36  34-3  33
35  36

31  32-1  31  32-2  31  31  32-3  31

30

**Fig. 8D**

A₁          A₂          A₃

(TA)  (FGT)
36-1  34-1  38  39-1  36-3  39-3
21  37  39  39  37
50
33  35  33  36  35  36

31  32-1  31  32-2  31  31  32-3  31  33

30

**Fig. 8E**

11

**Office européen des brevets**

**RAPPORT DE RECHERCHE EUROPEENNE**

Numéro de la demande

EP 02 01 2964

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | PATENT ABSTRACTS OF JAPAN vol. 1999, no. 07, 31 mars 1999 (1999-03-31) -& JP 06 283721 A (OKO DENSHI KOFUN YUGENKOSHI), 7 octobre 1994 (1994-10-07) * abrégé; figures 4,5 * | 1-6,8,9 | H01L27/02 H01L21/8247 |
| A | | 7 | |
| X | FR 2 786 569 A (ST MICROELECTRONICS SA) 2 juin 2000 (2000-06-02) * figures 2,6 * * page 1, ligne 15 - page 2, ligne 18 * * page 5, ligne 3 - page 7, ligne 34 * | 1-5 | |
| A | | 6-9 | |
| A | EP 0 384 275 A (NAT SEMICONDUCTOR CORP) 29 août 1990 (1990-08-29) * figure 2 * * colonne 4, ligne 28 - colonne 5, ligne 35 * | 1-9 | |
| A | PATENT ABSTRACTS OF JAPAN vol. 1998, no. 12, 31 octobre 1998 (1998-10-31) -& JP 10 200077 A (SONY CORP), 31 juillet 1998 (1998-07-31) * abrégé; figures 1-7 * | 1-9 | DOMAINES TECHNIQUES RECHERCHES (Int.Cl.7) H01L |

Le présent rapport a été établi pour toutes les revendications

| Lieu de la recherche | Date d'achèvement de la recherche | Examinateur |
|---|---|---|
| BERLIN | 25 septembre 2002 | Polesello, P |

**ANNEXE AU RAPPORT DE RECHERCHE EUROPEENNE
RELATIF A LA DEMANDE DE BREVET EUROPEEN NO.**

EP 02 01 2964

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-09-2002

| Document brevet cité au rapport de recherche | | Date de publication | Membre(s) de la famille de brevet(s) | | Date de publication |
|---|---|---|---|---|---|
| JP 06283721 | A | 07-10-1994 | AUCUN | | |
| FR 2786569 | A | 02-06-2000 | FR | 2786569 A1 | 02-06-2000 |
| EP 0384275 | A | 29-08-1990 | US | 4985717 A | 15-01-1991 |
| | | | CA | 1290463 A1 | 08-10-1991 |
| | | | DE | 69009221 D1 | 07-07-1994 |
| | | | DE | 69009221 T2 | 15-12-1994 |
| | | | EP | 0384275 A2 | 29-08-1990 |
| | | | JP | 2277271 A | 13-11-1990 |
| | | | JP | 2963482 B2 | 18-10-1999 |
| JP 10200077 | A | 31-07-1998 | AUCUN | | |

EPO FORM P0460

Pour tout renseignement concernant cette annexe : voir Journal Officiel de l'Office européen des brevets, No.12/82